# EUROPEAN PATENT APPLICATION

(11) **EP 1 357 607 A1**
(43) Date of publication of application: **29.10.2003**
(21) Application number: 01995003.9
(22) Date of filing: 25.12.2001
(51) Int. Cl.: H01L 31/04

(54) **SOLAR CELL**

(30) Priority: 26.12.2000 JP 2000396080; 26.12.2000 JP 2000396181
(71) Applicant: Kabushiki Kaisha Hayashibara Seibutsu Kagaku Kenkyujo, Okayama-shi, Okayama 700-0907 (JP)
(72) Inventor: MATSUI, Fumio, Okayama-shi, Okayama 700-0907 (JP); KOYAMA, Toshiki, Ueda-shi, Nagano 386-0003 (JP); TANIGUCHI, Yoshio, Ueda-shi, Nagano 386-0012 (JP); MITEKURA, Hirofumi, Okayama-shi, Okayama 700-0907 (JP); YANO, Kentaro, Okayama-shi, Okayama 700-0907 (JP); OHTAKA, Hedeo, Okayama-shi, Okayama 700-0907 (JP)
(74) Representative: Jenkins, Peter David
(86) International application number: JP0111381
(87) International publication number: WO02052654

(57) **Abstract**

The present invention aims to provide a solar cell which has an improved processibility suitable for industrial-scale and which is easily prepared at a lower cost. The object is solved by establishing the following solar cell and uses thereof; a solar cell comprising a pair of substrates which each has at least two insulatedly divided transparent electrically-conductive film layer regions and at least one semiconductor layer placed partially and stackingly on at least one of the transparent electrically-conductive film layer regions, wherein a transparent electrically-conductive film layer and a semiconductor layer, that are positioned on the same transparent electrically-conductive film layer region placed on one substrate, are respectively positioned so as to be opposed to a semiconductor layer positioned on a transparent electrically-conductor layer region on the other substrate and another transparent electrically-conductive film layer positioned on another transparent electrically-conductive film layer region placed on the other substrate.

## Description

### Technical Field

The present invention relates to a novel solar cell and uses thereof, more particularly, to a solar cell having an advantageous processibility suitable for industrial-scale production and being easily produced at a lower cost, and uses thereof.

### Background Art

Recently, solar cells have been eagerly researched from various aspects to improve their light energy conversion efficiency, durability, and operation stability; there have been made many trials for improving the voltage and current of solar cells by connecting unit cells in series or in parallel, or for effectively using light by positioning a reflection layer on either surface of a pair of substrates. In these researches, however, the production easiness and the production cost of solar cells have been put aside as a subordinate. Therefore, even if solar cells with a satisfactory light energy conversion efficiency, durability, and operation stability were developed, there still remained many cases that the actual productions thereof were difficult in terms of their production easiness and production costs.

Under these circumstances, a solar cell, which has a satisfactory light energy conversion efficiency, durability, and operation stability and which is easily produced at a lower cost, has been in a great demand.

The present invention aims to provide a solar cell, which has a satisfactory light energy conversion efficiency, durability, and operation stability and which is easily produced on an industrial scale and at a lower cost.

### Disclosure of Invention

To solve the above object, the present inventors made this invention by providing a solar cell, which has an improved processibility suitable for industrial-scale and which is easily prepared at a lower cost, comprising a pair of substrates which each has at least two insulatedly divided transparent electrically-conductive film layer regions and at least one semiconductor layer placed partially and stackingly on at least one of the transparent electrically-conductive film layer regions, wherein a transparent electrically-conductive film layer and a semiconductor layer, that are positioned on the same transparent electrically-conductive film layer region placed on one substrate, are respectively positioned so as to be opposed to a semiconductor layer positioned on a transparent electrically-conductor layer region on the other substrate and another transparent electrically-conductive film layer positioned on another transparent electrically-conductive film layer region placed on the other substrate.

### Brief Description of Drawings

FIG. 1 is a figure of an example of the solar cell of the present invention.
FIG. 2 is a figure of another example of the solar cell of the present invention.
FIG. 3 is a figure of another example of the solar cell of the present invention.
FIG. 4 is a figure of a conventional solar cell.
FIG. 5 is a figure of another example of the solar cell according to the present invention.
FIG. 6 is a figure of the other example of the solar cell of the present invention.

### Explanation of Symbols:

- 1, 1': Substrates
- 2: Transparent electrically-conductive layer
- 3, 3a, 3b, 3c: Semiconductor layers
- 4: Electrode layer
- 5: Electrolyte layer
- 6, 6a, 6b, 6c, 6d, 6e, 6f, 6g: Insulating walls
- 7, 7': Spacers
- 8: Electrically-conductive material
- a, a1 to a14, b1 to b18: Cut/removed part of transparent electrically-conductive film layers
- A(b), A(c), B(c): Electrode layers
- A(d), B(d), B(e): Semiconductor layers
- f1 to f4: Electrolyte-injection holes

### Best Mode for Carrying Out the Invention

Explaining now the solar cell of the present invention, the substrates used in the present invention include any of conventionally used substrates comprising materials, which have an adequate strength and stably hold electrolytes, such as glasses, plastics, polyesters, and polycarbonates. Among these substrates, transparent substrates, which comprise materials capable of efficiently transmitting light, are preferably used.

The transparent electrically-conductive films used in the present invention include those which have a total light transparency of at least 70%, preferably, at least 90%, and a relatively low surface resistivity; tin oxide, fluorine-doped tin oxide, indium oxide, oxidized-copper-doped indium oxide, antimony-doped tin oxide, and aluminum-doped zinc oxide. Any semiconductor layers can be used as such in the present invention as long as they are preparable from semiconductor particles, independently of their materials and preparation methods. Examples of such semiconductor layers preferably used are those which comprise one or more materials selected from TiO₂, Nb₂O₃, ZnO, ZrO₂, Ta₂O₅, SnO₂, WO₃, CuAlO₂, CuGaO₂, In₂O₃, CdS, GaAs, InP, AlGaAs, CdTe, Cu₂S, CuInSe₂, CuInS₂, etc. In preparing the above semiconductor layers, photosensitizing dyes are doped on semiconductors to improve their light energy conversion efficiency to meet their use. As the above photosensitizing dyes, any of those which absorb light in a visible, infrared, and/or ultraviolet regions capable of exciting the above semiconductors can be used. Examples of such are organic dyes and metal complexes. The organic dyes include cyanine dyes such as NK1194, NK2071, NK2426, NK2501, and NK3422, which are products of Hayashibara Biochemical Laboratories Inc., Okayama, Japan; polymethine dyes such as copper phthalocyanine, titanyl phthalocyanine, polychlorocopper phthalocyanine, monochlorocopper phthalocyanine, polybromocopper phthalocyanine, cobalt phthalocyanine, nickel phthalocyanine, iron phthalocyanine, tin phthalocyanine, C.I. pigment blue 16, and the cyanine dyes disclosed in International Patent Application No. PCT/JP00/02349 applied for by the same applicant as the present invention, phthalocyanine dyes, melocyanine dyes, naphthalocyanine dyes, and derivatives thereof. Another examples of the organic dyes include xanthene dyes such as uranin, eosin, rose bengal, rhodamine B, rhodamine 123, rhodamine 6G, erythrosine B, dichlorofluorescein, fluorescein, aminopyrogallol, 4,5,6,7-tetrachlorofluorescein, fluoresceinamine I, fluoresceinamine II, and dibromofluorescein; triphenylmethane dyes such as malachite green and crystal violet; and derivatives thereof. Further examples of the organic dyes are coumarins or other compounds with the coumarin skeleton such as pyrene, methylene blue, thionine, coumarin 343, 4-trifluoromethyl-7-dimethylaminocoumarin, and derivatives thereof; modant blue-29; eriochrome cyanine R; aurin tricarboxylic acid; naphthochrome green; and derivatives thereof. In addition to the above organic dyes, inorganic pigments such as carbon black; azo compounds such as C.I. disperse yellow 7, C.I. solvent red 23, C.I. pigment blue 25, C.I. pigment red 41, C.I. acid red 52, C.I. basic red 3, disperse diazo black D, permanent red 4R, dinitroaniline orange, permanent red GY, permanent carmine BS, disazo yellow, and disazo orange; perinone compounds such as perinone orange; perylene compounds such as perylene scarlet and perylene maroon; quinacridone compounds such as quinacridine red and quinacridone violet; isoindoline compounds such as isoindoline yellow; dioxadine compounds such as dioxazine violet; quinophthalone compounds such as quinophthalone yellow; quinone compounds; quinone imine compounds; squalillium compounds; melocyanine compounds; xanthene compounds; porphyrin compounds; indigo compounds such as C.I. vat brown 5 and other C.I. vat dyes; perylene compounds such as algo scarlet B and indanthrene scarlet R; oxadine compounds; diketopyrrole compounds; anthraquinone compounds; and derivatives thereof. Also the organic dyes include the following metal complex organic dyes such as chlorophyll and derivatives thereof; ruthenium bipyridyl complexes such as ruthenium-tris(2,2'-bispyridyl-4,4'-dicarboxylate), ruthenium-cis-dithiocyano-bis(2,2'-bipyridyl-4,4'-dicarboxylate), ruthenium-cis-diaqua-bis(2,2'-bipyridyl-4,4'-dicarboxylate), ruthenium-cyano-tris(2,2'-bipyridyl-4,4'-dicarboxylate), cis- (SCN⁻) -bis(2,2'-bipyridyl-4,4'-dicarboxylate)ruthenium, ruthenium-cis-dicyano-bis(2,2'-bipyridyl-4,4'-dicarboxylate), and ruthenium(II) (4,4'-dicarboxy-2,2'-bipyridyl)₂(SCN)₂; fluorescent brightening compounds such as 1,2-bis(benzoxazolyl)ethylene derivatives and 4-methoxy-N-methylnaphthalic acid imide; rhodanine derivatives such as 3-ethyl-5-[4-(3-ethyl-2-benzothiazolidene-2-hexenilidene]rhodanine; 4-(dicyanomethylene)-2-methyl-6-(*p*-dimethylaminostyryl)-4H-pyrane; and metal complexes containing iron or zinc such as zinc-tetra(4-carboxyphenyl)porphyrin, iron-hexacyanide complex, and hemin. One or more of the above photosensitizing dyes can be used in an appropriate combination.

The electrode layers used in the present invention can made of or from carbons, graphites, carbon nanotubes, platinum, gold, silver, titanium, vanadium, chromium, zirconium, niobium, molybdenum, palladium, tantalum, tungsten, and their alloys, as well as electrically conductive plastics.

Any liquid electrolytes and solid electrolytic materials, which are used generally in this field as electrolyte layers, can be used in the present invention. Examples of such liquid electrolytes are those in a solution form prepared by dissolving, for example, one or more electrochemically active salts and one or more compounds capable of forming a redox system in a solvent, capable of dissolving the compounds, such as acetonitrile, ethylene carbonate, propylene carbonate, methanol, ethanol, and butanol. Examples of the electrochemically active salts include tertiary ammonium salts such as tetra-n-propyl ammonium iodide. The compounds capable of forming a redox system include quinone, hydroquinone, iodine, potassium iodide, bromine, and potassium bromide. Examples of the solid electrolytic materials include zirconia solid electrolytes, hafnium solid electrolytes, gel electrolytes, and other solid electrolytes comprising high molecules such as polyethylene oxides and polyethylene having salts of sulfonamide, alkylimidazolium, tetracyanoquinodimethane, or dicyanoquinodiimine at their side chains.

The binders used in the present invention include those which are generally used in this field: For example, cellulose adhesives such as hydroxypropyl cellulose; alkyd adhesives; acryl esters, polyacrylic acid, polyamides, polystylenes, synthetic rubbers, polyethylene glycols, poly(vinylpyrrolidone), poly(vinyl alcohol), urea resins, melamine resins, phenol resins, resorcinol resins, furan resins, epoxy resins, unsaturated polyesters, anionic surfactants, cationic surfactants, non-ionic surfactants, and amphoteric surfactants, which can be use alone or in an appropriate two or more combination. The binders improve the viscosity of suspensions of semiconductor particles in the form of a colloidal solution, and they facilitate the homogeneity, contiguity, and density of the resulting semiconductor layers formed after drying. Varying depending on the types of binders used, the concentration of the binders is usually 1 to 99% by weight, preferably, 20 to 40% by weight to that of the total semiconductor particles. Among the above binders, polyethylene glycols are most preferably used, usually, those with a molecular weight of 100 to 100,000, preferably, 500 to 50,000, and more preferably, 10,000 to 30,000, are suitably used.

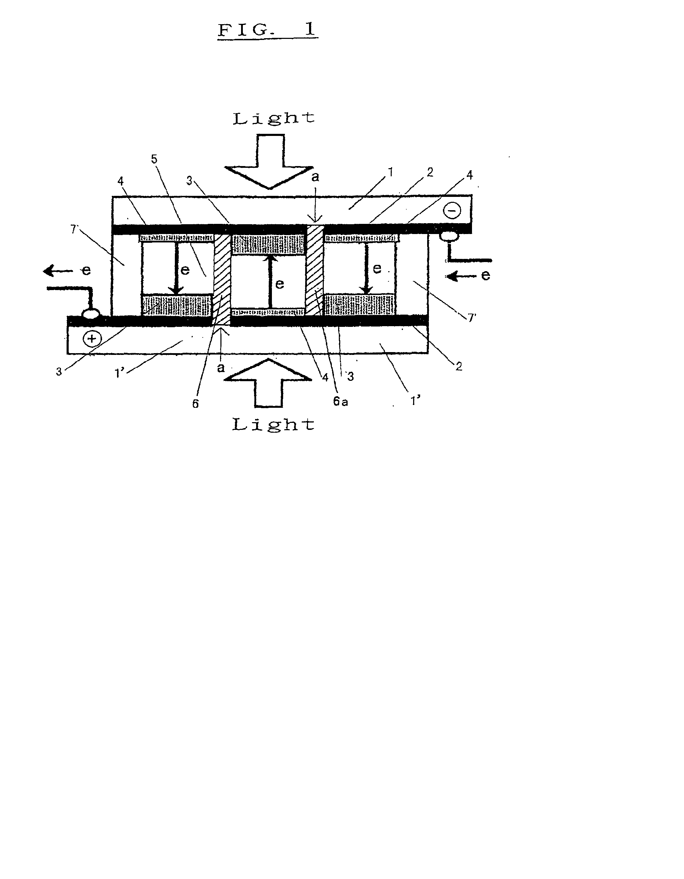

The process for producing the solar cell of the present invention using the above materials is explained with reference to FIG. 1. Firstly, a transparent electrically-conductive layer region 2 is placed over appropriate substrates 1, 1' by a conventional method such as spray pyrolysis method, spattering method, vacuum evaporation method, or chemical vapor deposition (CVD) method. The resulting transparent electrically-conductive layer region 2 is partially cut/removed in such a mechanical or chemical manner at a prescribed part as shown in the cut/removed part "a" of the transparent electrically-conductive layer in FIG. 1 so as to form a plural insulated blocks of the transparent electrically-conductive layer region 2 over the substrates 1, 1', where the adjacent transparent electrically-conductive layer regions 2, 2 are electrically insulated mutually. In the case of placing the transparent electrically-conductive layer region 2 to be separated into a plural blocks on the substrates 1, 1', either a molding box is closely attached unto the substrates 1, 1' or the blocks are treated for masking so as not to form the transparent electrically-conductive layer region 2 on the parts to be insulated and separated into the desired plural blocks over the substrates 1, 1' before forming the transparent electrically-conductive layer region 2. Thus, a plurality of transparent electrically-conductive layer regions 2, which are insulated and separated into a plural blocks over the substrates 1, 1', can be easily prepared at a relatively low cost. Secondary, a semiconductor layer 3 and an electrode layer 4 in FIG. 1 are formed by the following method.

Methods for forming the electrode layer 4 include a conventional heat treatment comprising the steps of applying a solution containing a metal salt or an organic metal compound on a prescribed part of the transparent electrically-conductive layer region 2, and drying and baking the resultant; an irradiation treatment with electromagnetic waves such as activation lights; and conventional methods such as spray-pyrolysis method, spattering method, vacuum evaporation method, and CVD method. The electrode layer 4 has a thickness, usually, of one micrometer or lower, preferably, 100 nm or lower, more preferably, 10 nm or lower, and more preferably, 0.1-10 nm. The electrode layer 4 is not an essential element in the present invention, however, it is preferably formed on the transparent electrically-conductive layer to improve its electroconductivity, reflectability, anti-corrosiveness, and electron migration.

Methods for forming the semiconductor layer 3 are as follows: A suspension of semiconductor particles is coated over the substrates 1, 1' doped with the transparent electrically-conductive layer region 2 to give a wet thickness of 0.1-1,000 µm, preferably, 1-500 µm, more preferably, 1-300 µm, and more preferably, 1-100 µm. As the methods for such a coating, conventional dipping method, spinner method, spraying method, roll coater method, screen printing, flexographic printing, gravure printing, blade coating, bar coating, and CVD method can be appropriately employed. Then, the resulting coated layer is dried, baked in a usual manner to form a porous thin-layer, and cooled to ambient temperature to obtain the desired semiconductor layer 3 having usually a thickness of 0.01-1,000 µm. If necessary, photosensitizing dyes can be doped on the semiconductor layer 3 to improve the light energy conversion efficiency. The above-mentioned coating method can be used as a method for such a doping. In this case, the photosensitizing dyes are used in a form dissolved in an appropriate solvent or in a supersaturated form. Any solvents can be used as long as the photosensitizing dyes dissolve therein; alcohols such as methanol, ethanol, 2-methoxyethanol, 2-ethoxyethanol, 1-propanol, 2-propanol, isopropanol, 2,2,2-trifluoroethanol, 1-butanol, 2-butanol, isobutyl alcohol, isopentyl alcohol, and benzyl alcohol; organic compounds such as methyl cellosolve, ethyl cellosolve, cyclohexanol, acetone, acetonitrile, anisole, pyridine, phenol, benzene, nitrobenzene, chlorobenzene, toluene, naphthalene, formamide, N-methylformamide, N,N-dimethylformamide, hexamethylphosphoamide, dimethylsulfoxide, sulfolane, cresol, ether, diethylether, diphenyl ether, 1,2-dimethoxyethane, chloroform, dichloromethane, 1,2-dichloroethane, 1,4-dioxane, N-methylpyrolidone, tetrahydrofuran, hexane, cyclohexane, carbon tetrachloride, formic acid, acetic acid, acetic anhydride, trichloroacetate, trifluoroacetate, ethyl acetate, butyl acetate, ethylene carbonate, propylene carbonate, formamide, nitrile, nitro compounds, amines, and sulfur-atom containing compounds; glycols such as ethylene glycols and propylene glycols; one or more of which can be used alone or in an appropriate mixture form. These solvents and mixtures should preferably be dehydrated prior to use. Each of the photosensitizing dyes is formed over the semiconductor layer, for example, by a coating method in an amount of at least 10 µg, preferably, at least 50 µg/cm², and more preferably, at least 70 µg per one square centimeter of specific surface. There is no upper limit of the amount of photosensitizing dyes used and it should be considered in terms of production costs. If necessary, to lower the internal resistance at the contact parts of the semiconductor particles relative to one another in the semiconductor layer 3, for example, when the semiconductor layer 3 is composed of TiO₂ particles, TiCl₄ is dropped into cold or hot water to form TiOH, followed by soaking the semiconductor 3 in the solution for necking treatment. This treatment can be appropriately practiced depending on the types of the semiconductor particles used. The resulting semiconductor layer 3 is treated to be non-conductive. Such a treatment is to prevent the transparent electrically-conductive layer region 2, formed over the substrates 1, 1', from directly contacting with an electrolyte layer 5 in the form of a liquid electrolyte. As long as the object is attainable, such a treatment should not be specific one. Usually, agents for non-conductive treatment are dropped, doped, adsorbed, or applied over or unto the semiconductor layer 3 for such a purpose. Examples of the agents include pyridine compounds such as 4-tetra-butylpyridine and dyes/pigments having a carboxyl group or a functional group which binds to titanium atom.

As shown in FIG. 1, the distance between the semiconductor layer 3 positioned on the substrate 1 and either the transparent electrically-conductive layer region 2 or the electrode layer 4 on the substrate 1' is usually set to about 10-1,000 µm, preferably, about 50-500 µm. Although FIG. 1 shows three pairs of the semiconductor layer 3 and the electrode layer 4, i.e., three pairs of solar cells, any pairs of at least two pairs of such solar cells can be practiced in the present invention. By altering the number of pairs of the semiconductor layer 3 and the electrode layer 4, the voltage and the current of the solar cell of the present invention can be suitably designed. To improve the light conversion efficiency and electromotive force, the above solar cells can be doped with different photosensitizing dyes, having absorption peaks at different wavelength regions, into solar cells as wavelength division solar cells cascaded in parallel or in series.

As shown in FIG. 1, two substrates, upon which the transparent electrically-conductive layer region 2 and the semiconductor layer 3 are formed and which may have the above-mentioned electrode layer 4, are positioned at a prescribed distance in such a manner of allowing the semiconductor layer 3 and the electrode layer 4 to be opposed each other, sealing the both ends of the substrates 1, 1' with the spacers 7, 7' to form a gap/space for holding the electrolyte layer 5. The spacers 7, 7' can be made of any of non-conductive materials which have an adequate physical strength and hold the electrolyte layer 5, preferably, those which are made of transparent materials to improve the light energy conversion efficiency of the solar cell of the present invention. The substrate 1 or 1' is then perforated to form a hole(s) at an adequate point(s), not shown in FIG. 1, followed by injecting a liquid or solid electrolyte as the electrolyte layer 5 into the above-mentioned gap/space in a usual manner. For example, in the case of using a liquid electrolyte as the electrolyte layer 5 in this example, the liquid electrolyte can be injected through an opening provided for installing the spacer 7' after installing the spacer 7 or before installing the spacer 7'. In this case, the opening for installing the spacer 7' can be dipped in a liquid electrolyte to allow the liquid electrolyte to be penetrated/injected into the gap/space via the action of capillarity, and then closed with the spacer 7'. The spacers 7, 7' can be partially cut off to form openings, and either of which is dipped in a liquid electrolyte, followed by compulsorily aspirating air through the other opening to induce the electrolyte into the electrolyte layer 5 for filling and sealing the openings. This method is advantageously applicable to materials with a relatively high viscosity, which are to be injected into the electrolyte layer 5. Although insulation separators 6, 6a in FIG. 1 are not essential, when installed, they form a gap/space surrounded with a pair of a part of the transparent conductive layer region 2 and the semiconductor layer 3 which are faced each other, whereby unfavorable electron transportation in the electrolyte layer 5 is restricted to improve the power generation efficiency of the solar cell.

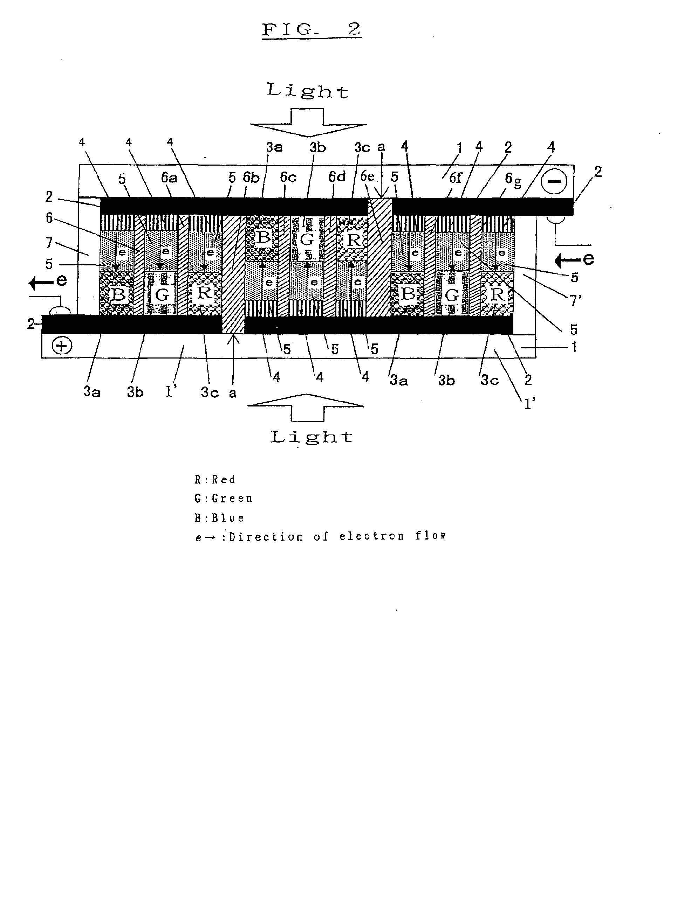

To stabilize and improve the light energy conversion efficiency and the electromotive force of the solar cell of the present invention in FIG. 1, the three cells for composing the solar cell can be divided into three types of wavelength division solar cells in FIG. 2, i.e., three different types of semiconductor layers 3a, 3b and 3c which are respectively doped with a photosensitizing dye having a main peak at a wavelength of blue, green or red light region; and connected in parallel as shown in FIG. 2 into a solar cell consisting of nine wavelength division solar cells. The solar cell in FIG. 2 can be produced in accordance with the process for producing the solar cell in FIG. 1. The solar cell in FIG. 2 is designed by connecting in parallel a set of three wavelength division solar cells to overcome the problem of unstable operability caused by variable currents that run through the wavelength division solar cells. In the solar cell in FIG. 2, any of liquid and solid electrolytic materials can be used as the electrolyte layer 5. Usually, the maximum electromotive force, i.e., open voltage (Voc) of each of the wavelength division solar cells is preferably set to a range of about ± 0.1 V. If necessary, the wavelength division solar cells can be composed of two out of the three types of semiconductor layers 3a, 3b and 3c as mentioned above, or can be composed of those which have at least one semiconductor layer doped with another photosensitizing dye(s) having a main absorption peak at a wavelength in a blue, green, or red light region differing from those mentioned as in the above, where two or more of the resulting semiconductor layers can be used in a free order and combination.

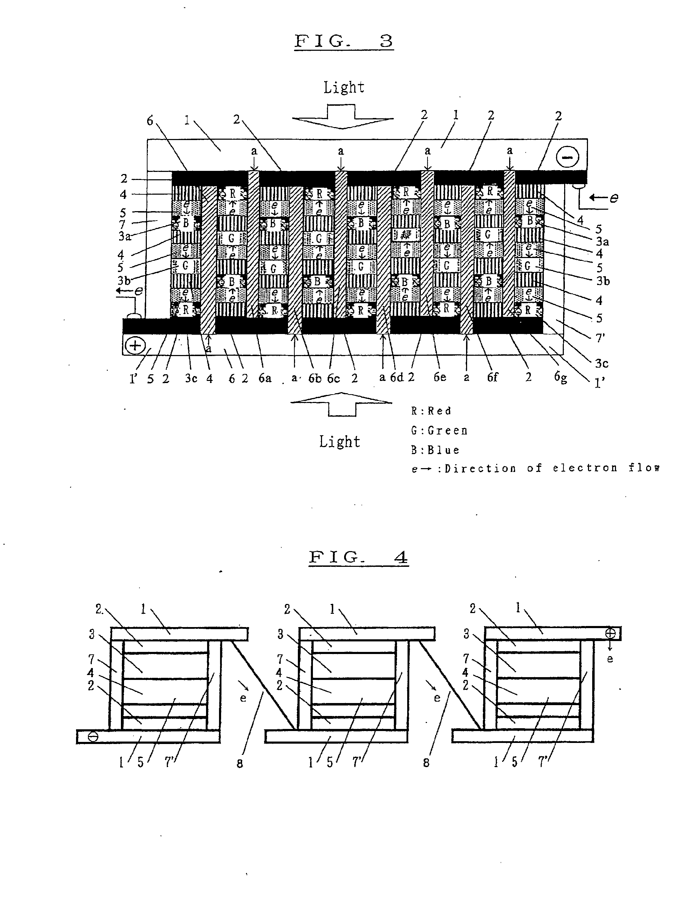

To more stabilize and improve both the light energy conversion efficiency and the electromotive force of the solar cell of the present invention in FIG. 1, a set of three wavelength division solar cells in FIG. 3, which have three different types of semiconductor layers 3a, 3b and 3c that are respectively doped with a different photosensitizing dye having a main peak at a wavelength of blue, green, or red light region; and connected in series as shown in FIG. 3 to form a solar cell composed of a plural wavelength division solar cells. The solar cell in FIG. 3 can be produced in accordance with the process for producing the solar cell in FIG. 1 in such a manner of providing a solid electrolytic material as an electrolyte layer; forming on the substrates 1, 1' a transparent electrically-conductive layer region 2, semiconductor layers 3, 3a, 3b, and 3c, electrode layer 4, and electrolyte layer 5 in the order as indicated in FIG. 3; and sealing the gap/space formed by the substrates 1, 1', with spacers 7, 7'. The solar cell in FIG. 3 is constructed by cascading three types of wavelength division solar cells in series into a set, and cascading a plural sets in series into a solar cell composed of nine sets in total. In the solar cell in FIG. 3, the electrolyte layer 5 can be constructed with a liquid electrolyte, however, when constructed with a solid electrolytic material, a plural sets, which each consists of three wavelength division solar cells in FIG. 3, are vertically multilayered to increase their packing density for obtaining a compact solar cell, as well as for advantageously improving the operation stability and facilitating an industrial scale, low cost production thereof by employing a conventional printing method. Usually, the maximum electromotive force of each of the wavelength division solar cells is preferably set to a range of about ± 0.1 V. The insulation separators 6 and 6a to 6g in FIGs. 2 and 3 are not structurally essential, however, they advantageously restrict undesired electron transportation through an electrolyte layer and improve the power generation efficiency of the solar cell. FIGs. 1 to 3 illustrate the electron flow running through the solar cell of the present invention.

Before referring to the function and effect of the solar cell of the present invention, conventional solar cells inevitably require the steps of separatory preparing a plural cells for composing a solar cell which comprises substrates 1, 1', transparent electrically-conductive layer region 2, semiconductor layer 3, electrode layer 4, electrolyte 5, and spacers 7, 7'; and connecting these elements in series with an electrically-conductive material 8. These steps need quite complicated handling which account for about 20% of the production cost of each of the conventional solar cells.

While, since the solar cell of the present. invention as described above has a structure suitable for an industrial scale production, it exerts an advantageous feature and function of reducing the production cost of conventional solar cells, preferably, by about 20%. Not only having a low production cost, the solar cell of the present invention has also an advantageous light energy conversion efficiency, durability, and operation stability.

Thus, the present invention lowers the production costs of apparatuses which need solar cells or electric powers. Examples of apparatuses, appliances, and articles, to which the solar cell of the present invention is applicable, are construction materials such as roof tiles, panes, window shades, garden illuminations, and outside walls; electric products such as calculators, stationeries, clocks/watches, telephones including portable phones, facsimiles, copying machines, radios, CD players, MD players, DVD players, televisions, videos, personal computers (PC), PC-related appliances, audios, game machines, electric thermometers, electric pedometers, electric weighing machines, electric torches, electric washing machines, microwave ovens, cleaners, humidifiers, electric rice cookers, desk lamps, air-conditioners/ventilators, interior/exterior illuminations which all need electric powers; communication apparatuses including portable phones; electric musical instruments, precision instruments/machines; street lamps; toys; information displays and signs such as poster columns/panels/notice-boards, signposts, induction beacons, buoys, and lighthouses; electric instruments and machines including power-generating instruments and machines such as articles for carpenters and plasterers, electric wheelchairs, bicycles, automobiles, heavy equipments, ships, airplanes, satellites, space ships, and space stations; power units/suppliers including solar power units; and systems with solar heat. The solar cell of the present invention can be used in an appropriate combination with a battery means, AC (alternating current)/DC (direct current) converting means, voltage-controlling means, and current-controlling means such as double layer condensers, lead-acid batteries, nickelcadmium batteries, nickel-hydrogen batteries, lithium-ion batteries, lithium batteries, oxidation silver/zinc batteries, nickel/zinc batteries, polymer batteries, and superconductive fly foil batteries, whereby the generated powers are continuously or incontinuously supplied to all the above-mentioned devices, apparatuses, instruments, and machines. To improve the light conversion efficiency of sunlight in the solar cell of the present invention, it can be installed with a means for tracking the movement of the sun in the daytime. In addition to sunlight, the solar cell of the present invention can use artificial lights such as in- and out-door lights.

The following Experiment and Example explain the present invention in detail:

### Experiment

### Solar cell

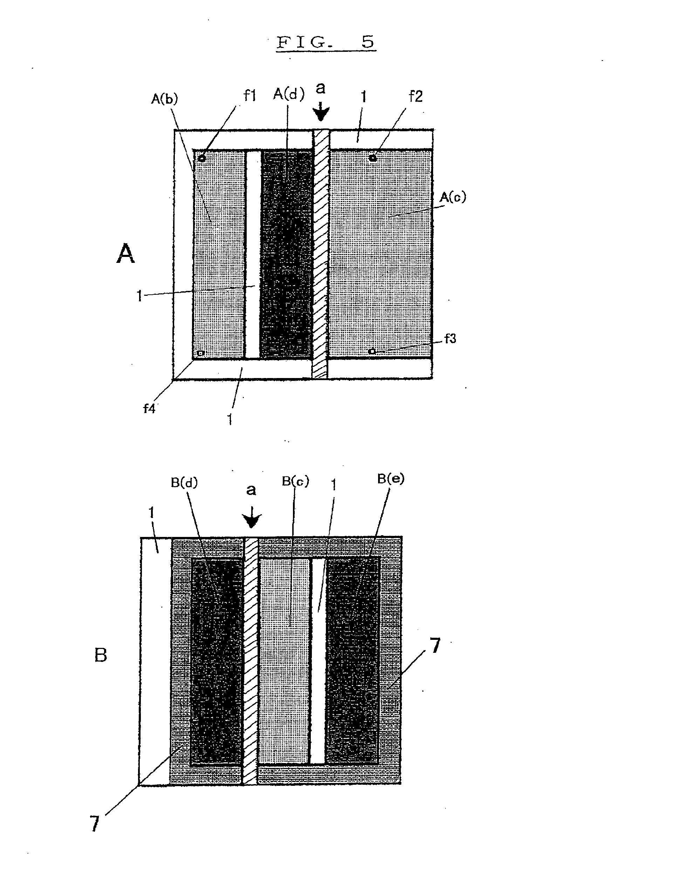

A substrate 1, "TCO" commercialized by Asahi Glass Co. Ltd., Tokyo, Japan, a fluorine-doped SnO₂, 1.1 mm in thickness, haze percentage of 10%, which had been prepared by coating a transparent electrically-conductive layer over a glass plate as a substrate, was treated to remove the part of tin dioxide layer, illustrated by the part "a" on the substrate 1 in FIG. 5 A, using a minirouter; and ultrasonically washed with a neutral detergent, alcoholic neutral detergent, and pure 2-propanol for one minute. Except for the surface for platinum spattering as an electrode layer, the substrate 1 was masked with a detachable viscous tape and deposited with platinum to give a thickness of 5 nm by the spattering method as illustrated in A(b) and A(c) in FIG. 5 A. Thereafter, the tape was detached from the substrate 1, deposited to form a layer with a composition containing 5% (w/w) of a rutile TiO₂ having a mean average particle size of 100 µm and 20% (w/w) of a polyethylene glycol to the weight of an anatase TiO₂ paste having a particle size of 24 µm and 12 µm (=4:1 by weight) by the doctor blade method, and baked at 450_C for 30 min to form a semiconductor layer with a thickness of about 10 µm as illustrated in A(d) in FIG. 5 A. The resulting baked substrate was cooled to 80_C and soaked for 12 hours in a distilled ethanol solution containing 3.0 x 10⁻⁴M of "NK-2071™", a photosensitizer commercialized by Hayashibara Biochemical Laboratories Inc., Okayama, Japan, to dope the photosensitizer thereupon. An excessive amount of the photosensitizer remained on the substrate 1 was washed with dry ethanol, dried in an atmosphere of nitrogen, and soaked in 4-*t*-butylpyridine for 15 min to obtain a substrate A formed with the semiconductor layer A(d) and electrode layers A(b), A(c) in FIG. 5 A. Similarly as in FIG. 5 A, another substrate B, formed with semiconductor layers B(d), B(e) and an electrode B(c) in FIG. 5 B, was prepared. "HIMILAN®", a polyester film having a thickness of 0.05 mm, commercialized by E.I. de Pont de Nemours and Co, USA, as a spacer 7 was sandwiched by the substrates A and B for stably holding them in such a manner of placing the semiconductor layers to be correspondingly faced with the electrode layers, i.e., pairs of A(d) and B(c), A(b) and B(d), and A(c) and B(e). The resulting substrates A and B are provisionally fixed with a double clip, heated at 130_C for 10 min to fuse HIMILAN® to be attached to the substrates A and B and to form a gap/space as an electrolyte layer. An electrolytic solution containing 30 mM I₂ and 300 mM LiI in CH₃CN/3-methyl-2-oxazolydine (=1:1 by volume) was injected into the gap/space through electrolyte-injection holes which had been previously perforated on the substrate A, f1, f2, f3 and f4 in FIG. 5 A, followed by sealing the holes with a teflon tape to obtain a solar cell of the present invention which receives light through the substrates. In the case of providing insulation separators 6, 6a in FIG. 1 corresponding to the shaded area in FIG. 5, a plural openings are partly provided in a spacer 7 instead of providing electrolyte-injection holes f1 to f4, followed by soaking either of the openings in a liquid electrolyte, forcing to suck the air in the gap/space, as an electrolyte layer formed between the substrates A and B, from other opening to allow to inject the electrolyte into the gap/space through the above opening soaked.

The solar cell stably generated an electric power of about 2.1 V and 80-100 mA when irradiated with an artificial light with an air mass (AM) of 1.5 (100 mW/cm²) obtained by focussing the light of a 150 W xenon lamp, commercialized by Ushio Inc., Saitama, Japan, into a spot of 30 mm in diameter and allowing the resulting focused light to pass through a filter of "SHOT KG-5 FILTER".

### Example

### Solar cell

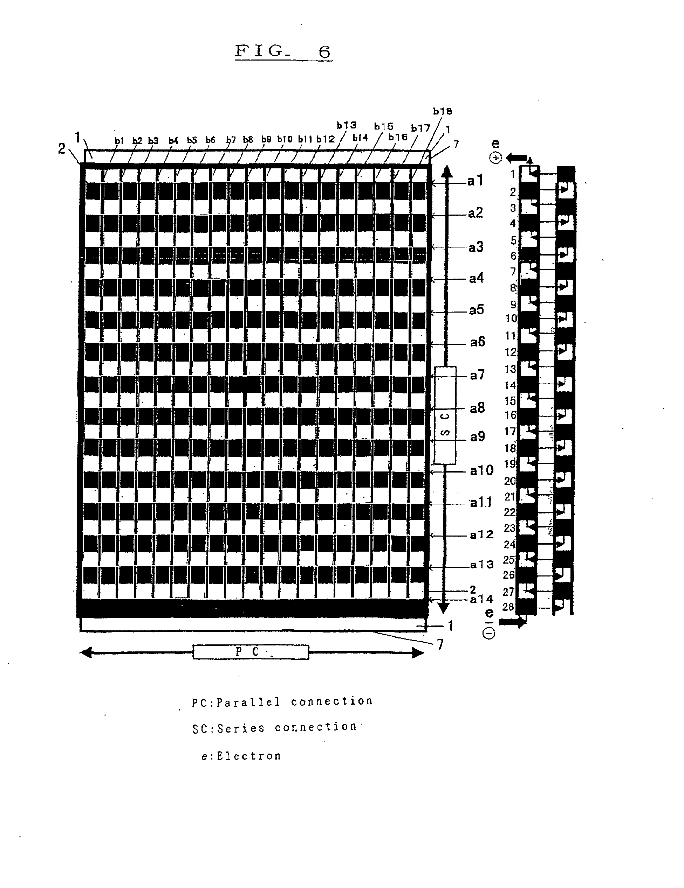

A solar cell in FIG. 6 was prepared by the following steps: An anatase-type titanium dioxide with an average particle size of 15 nm was suspended in an aqueous hydrochloric acid solution (pH 1) into a 20% (w/w) colloidal suspension which was then mixed and suspended with polyethylene glycol (MW 20,000), as a binder, which had been dissolved in an aqueous hydrochloric acid solution (pH 1), in an amount of 10% (w/w) to the semiconductor particles. The resulting suspension was screen printed on the parts represented by ■ of a substrate 1, which a transparent electrically-conductive layer had been formed over a glass plate, "ASAHI-TCO", commercialized by Asahi Glass Co. Ltd., Tokyo, Japan, a substrate fluorine-doped SnO₂ having 1.1 mm in thickness and a haze percentage of 10%. After drying by air, the resulting substrate was heated up to 450_C at an increasing temperature rate of 20.5_C/min under normal pressure by using "KDF-75", a vacuum baking furnace commercialized by Denken Co. Ltd., Kyoto, Japan, and then further baked at 450_C for 30 min and naturally cooled up to make the inner temperature to have ambient temperature. Thus, a plural semiconductor layers represented by ■ having a thickness of about 5 nm each were formed. An excessive amount of ruthenium II (4,4'-dicarboxy-2,2'-bipyridyl)₂(SCN)₂ as a photosensitizing dye was added to methanol in a special reagent grade to give a supersaturated solution of ruthenium II. Using the supersaturated solution, the resulting semiconductor layer formed on the baked substrate was doped with the photosensitizing dye by the dipping method. The methanol remained on the substrate was removed by drying by air, 4-tetra-butylpyridine was dropped on the semiconductor substrate to passivate the surface thereof to obtain a substrate composed of a plural semiconductor layers and a plural transparent electrically-conductive layers with no semiconductor layer which corresponded to the parts represented by □. To impart a satisfactory electroconductivity, reflectivity, and anti-corrosiveness, the transparent electrically-conductive layers with no semiconductor layer in FIG. 6 can be overlaid with an appropriate electrically-conductive layer made of platinum, gold, silver, or a transparent electrically-conductive plastic. Thereafter, the parts of a1 to a14 and the parts b1 to b14 were treated with the chemical etching method using a zinc powder to remove transparent electrically-conductive layers thereupon for partially insulating the transparent electrically-conductive layers in FIG. 6, whereby insulating the parts between □ and □ adjacent each other and the parts between ■ and ■ adjacent each other in a lateral direction, and the parts between □ and ■ which were adjacently positioned in this order in a vertical direction. In FIG. 6, b1 to b14 from which transparent electrically-conductive layers were removed, should not necessarily be provided.

Two plates of the substrates thus obtained, which were prepared by providing the transparent electrically-conductive layers and the semiconductor layers on a substrate, were placed to be faced each other to make a pair of a semiconductor layer ■ on one of the substrates and a transparent electrically-conductive layer □ on the other substrate. Two plates of "HIMILAN™" as a spacer 7 were held between the above substrates and provisionally fixed by a double clip, and then heated at 130_C for 10 min to be partially melted for fusion bonding to the substrates. A liquid electrolyte containing 30 mM I₂ and 300 mM LiI in CH₃CN/3-methyl-2-oxazolydinone (=1:1 by volume) was injected into an electrolyte layer through a plural electrolyte-injection holes, not shown in figure, provided at appropriate positions on the substrates, which were then sealed with a sealant to obtain a solar cell of the present invention which receives light through both outer surfaces of the substrates.

The electromotive force can be easily increased or decreased by appropriately changing the number of semiconductor layers ■ and transparent electrically-conductive layers □, which are formed on the substrates. The solar cell of the present invention has superior characteristics in that it has advantageous operability and stability and is easily produced on an industrial scale at a lower cost than conventional ones.

### POSSIBILITY OF INDUSTRIAL APPLICABILITY

As described above, the present invention relates to a solar cell which is superior in industrial processibility and which is easily produced at a lower cost compared with conventional solar cells. Since the solar cell of the present invention is superior in light energy conversion efficiency, durability, and operation stability, it facilitates to provide devices installed therewith as an electric power generator or high performance devices which need an electric power at a lower cost. Accordingly, the present invention will greatly contribute to this art.

## Claims

1. A solar cell comprising a pair of substrates which each has at least two insulatedly divided transparent electrically-conductive film layer regions and at least one semiconductor layer placed partially and stackingly on at least one of the transparent electrically-conductive film layer regions, wherein a transparent electrically-conductive film layer and a semiconductor layer, that are positioned on the same transparent electrically-conductive film layer region placed on one substrate, are respectively positioned so as to be opposed to a semiconductor layer positioned on a transparent electrically-conductor layer region on the other substrate and another transparent electrically-conductive film layer positioned on another transparent electrically-conductive film layer region placed on the other substrate.

2. The solar cell of claim 1, wherein said substrate is a transparent substrate.

3. The solar cell of claim 1 or 2, which receives light from both outer surfaces of the substrates.

4. The solar cell of claim 1, 2 or 3, wherein an electrically conductive layer is overlaid over said transparent electrically-conductive film layer opposite to said semiconductor layer.

5. The solar cell of claim 4, wherein said electroconductive layer is of which comprises one or more members selected from the group consisting of carbon, graphite, carbon nanotube, platinum, gold, silver, titanium, vanadium, chrome, zirconium, niobium, molybdenum, palladium, tantalum, tungsten, alloys thereof, and electrically conductive plastics.

6. The solar cell of any one of claims 1 to 5, wherein said semiconductor layer contains a photosensitizing dye and/or a binder.

7. The solar cell of any one of claims 1 to 6, wherein a gap/space formed between a pair of substrates positioned oppositely is not partitioned.

8. The solar cell of any one of claims 1 to 7, wherein the gaps/spaces, which are respectively formed between a pair of substrates positioned oppositely, are partitioned in a unit of a pair of said transparent electrically-conductive film layer and said semiconductor layer to form a solar cell comprising at least one unit of solar cell.

9. The solar cell of claim 8, which comprises at least two solar cell units are cascaded in series or in parallel.

10. The solar cell of claim 9, wherein said solar cell units are respectively composed of at least two wavelength division cells cascaded in series or in parallel.

11. The solar cell of any one of claims 1 to 10, which further contains a liquid electrolyte and/or solid electrolytic material as an electrolyte layer.

12. The solar cell of any one of claims 1 to 11, wherein a plural transparent electrically-conductive film layer regions, which are partially overlaid with said semiconductor layers, are positioned in line.

13. The solar cell of any one of claims 1 to 12, which is further installed with a battery means and/or a d.c./a.c. converting means.

14. The solar cell of any one of claims 1 to 13, which is further installed with a means for chasing the movement of the sun in the daytime.

15. A power supplying device, which comprises said solar cell of any one of claims 1 to 14 as a power generating means.
